# EUROPEAN PATENT SPECIFICATION

(11) **EP 0 439 326 B1**
(45) Date of publication and mention of the grant of the patent: **14.04.1999**
(21) Application number: 91300470.1
(22) Date of filing: 22.01.1991
(51) Int. Cl.: H04B 1/40, H03J 7/06

(54) **Digitally frequency-locking a radio transceiver to the received signal**
Verfahren zur digitalen Frequenzverriegelung eines Funksendeempfängers mit dem Empfangssignal
Procédé d'asservissement numérique de fréquence d'un radioémetteur-récepteur au signal reçu

(30) Priority: 22.01.1990 US 468040
(43) Date of publication of application: 31.07.1991
(73) Proprietor: MOTOROLA, INC., Schaumburg, IL 60196 (US)
(72) Inventor: Moller, Paul J., Streamwood, Illinois 60107 (US); Ford, David K., Mesa, Arizona 85203 (US); Main, Douglas W., Palatine, Illinois 60074 (US)
(74) Representative: Lupton, Frederick

(56) References cited:
- US-A- 4 498 191
- US-A- 4 703 520
- US-A- 4 805 230

## Description

### Background of the Invention

The present invention is generally related to radiotelephones, and more particularly to digitally frequency-locking a cellular telephone to the received signal.

In some countries, cellular telephones are required to meet a maximum transmitter frequency error specification. In order to maintain the transmitter frequency within the maximum transmitter frequency error specifications, such cellular telephones currently use an analog frequency control circuit which compares the received signal frequency to the cellular telephone reference oscillator to develop an analog correction voltage. The analog correction voltage is applied to the cellular telephone reference oscillator to frequency lock it to the received signal frequency, which is very accurately maintained by the base station radio. However, such prior analog frequency control circuits necessitate digital-to-analog conversion circuitry and analog comparators thereby incurring substantial additional costs.

US-A-4 498 191 discloses a microprocessor controlled phase locked loop tuning system which uses a single AFC detector whose threshold is controlled by the micropocessor. The system comprises a microporcessor which provides frequency data to a PLL and this data controls a programmable frequency divider in the PLL which determines the nominal frequency of a VCO in the tuner. An AFC detector in the intermediate frequency section provides an AFC voltage output to the single comparator. The comparator produces a logic "0" or logic "1" output to the microprocessor depending on whether the output from the AFC detector is above or below a predetermined threshold. The microprocessor may be programmed to cause the VCO frequency changes to be made in smaller increments. After a predetermined number of detector output state changes have been detected, the microprocessor is then operated in a track mode.

US-A-4 703 520 discloses a reference oscillator suitable for use in a radio transceiver having a phase locked loop FM detector. During normal reception operation, the reference oscillator can be controlled in closed loop manner through use of a phase locked loop that responds, in part, to the lock frequency of the FM detector phase locked loop. During transmit functions, open loop control can be provided instead. Open loop control includes use of a stored value that reflects a most recent reliable value of an appropriate input control signal for the reference oscillator.

### Objects of the Invention

Accordingly, it is an object of the present invention to provide a method of digitally frequency-locking a transceiver to the frequency of the received signal.

Accordingly, the invention provides a method for substantially frequency locking a reference oscillator signal of a reference oscillator (104) of a radio transceiver having a microcomputer (102) with a register, to the radio signal received by the radio transceiver, the register storing an initial frequency, said method comprising the steps of: dividing (102) the reference oscillator signal to produce a divided reference oscillator signal; generating (120) a synthesizer signal locked to the reference oscillator signal; mixing (122) the synthesizer signal and the received radio signal to produce an intermediate frequency signal; comparing (126) the frequency of the divided reference oscillator signal to the frequency of the intermediate frequency signal and producing an error signal (110) having a binary one state if the frequency of the divided reference oscillator signal is less than or equal to the frequency of the intermediate frequency signal, and a binary zero state if the frequency of the divided reference oscillator signal is greater than the frequency of the intermediate frequency signal; and setting (204) the reference oscillator to an initial stored frequency in the register when a signal is acquired or re-acquired by the radio transceiver; sampling (208, 228, 214) the binary state of the error signal at successive time intervals following the setting of the reference oscillator to the stored initial frequency, the time intervals having a first predetermined length of time, and increasing (224) the frequency of the reference oscillator by a first predetermined amount if the error signal has a binary one state and decreasing (210) the frequency of the reference oscillator by the first predetermined amount if the error signal has a binary zero state until the binary state of the error signal changes; when the binary state of the error signal changes a first time following the setting of the reference oscillator to the stored initial frequency, thereafter sampling the binary state of the error signal at successive time intervals each having a second predetermined length of time and increasing (216) the frequency of the reference oscillator by a second predetermined amount if the error signal has a binary zero state and decreasing (230) the frequency of the reference oscillator by the second predetermined amount if the error signal has a binary one state, said second predetermined amount being less than said first predetermined amount; when the binary state of the error signal changes a second time (234, 220) following the setting of the reference oscillator to the stored initial frequency, adjusting (302) the stored initial frequency an amount related to the difference between the frequency of the reference oscillator and the stored initial frequency and storing the adjusted initial frequency in the register for use the next time a signal is acquired or re-acquired whereby the initial frequency of the reference oscillator is updated for subsequent use to account for ageing that occurred since a last update.

The method of the invention provides digitally frequency-locking a transceiver to the frequency of the received signal and correcting the initial turn on frequency of the transceiver each time the transceiver is.frequency locked.

### Brief Description of the Drawings

Figure 1 is a block diagram of a cellular telephone 100 embodying the present invention.

Figure 2 is a flow chart for the process used by microcomputer 102 in Figure 1 for substantially frequency locking the reference oscillator 104 to the received signal.

### Detailed Description of the Preferred Embodiment

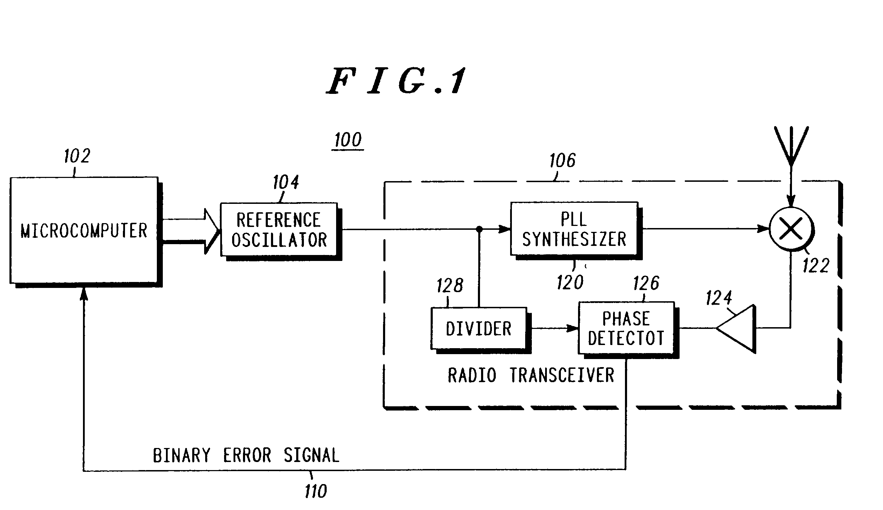

Referring to Figure 1, there is illustrated a block diagram of a cellular telephone 100 embodying the present invention. Cellular telephone 100 includes a radio transceiver 106, a reference oscillator 104, and microcomputer 102 with memory therein for controlling the operation thereof. Only the portion of transceiver 106 that generates the binary error signal 110 has been illustrated. According to the present invention, microcomputer 102 is responsive to the binary error signal 110 for frequency locking reference oscillator 104 to the radio signal received by radio transceiver 106. Radio transceiver 106 also includes a radio receiver and transmitter (not shown), which may be a Nordic-type 900 MHz cellular telephone transmitter and radio receiver, such as, for example, the transceiver shown and described in Motorola instruction manual number 86P09300A10, entitled "MICROTAC. Cellular Personal Telephone," published by and available from Motorola C & E Parts, 1313 East Algonquin Road, Schaumburg, Illinois 60196.

In the Nordic telephone system currently in use in Norway, Sweden, Denmark and Finland, the transmitter frequency of cellular telephone 100 must be within 900 Hertz of the specified transmitter frequency for each radio channel. Since the base station transmitter frequency is maintained within 250 Hertz of its specified transmitter frequency, cellular telephone 100 may be frequency locked to the received base station transmitter signal in order to meet the Nordic specifications. Since the frequency of reference oscillator 104 changes with time, it is also important to compensate for the frequency aging of reference oscillator 104 in order to meet the Nordic specifications, which further require that the frequency error of the cellular telephone transmitter be within specified limits within two seconds of acquisition of the base station transmitter signal over its entire operating life. By utilizing the present invention, microcomputer 102 is responsive to the binary error signal 110 for rapidly frequency locking reference oscillator 104 to the base station transmitter signal received by radio transceiver 106, such that the reference oscillator frequency is maintained within the Nordic specifications during the entire operating life of cellular telephone 100.

Referring to Figure 1, radio transceiver 106 includes a phase-locked loop (PLL) synthesizer 120, a receiver mixer 122 followed by one or more gain stages 124, a phase detector 126, and a reference oscillator divider 128. The PLL synthesizer 120 generates a signal locked to reference oscillator 104 that is mixed with the incoming base station transmitter signal in receive mixer 122 to generate an intermediate frequency signal that is then amplified by amplifier 124. The output of reference oscillator 104 also feeds a divider 128, which divides the reference oscillator signal by an amount so as to generate the divided signal having a frequency substantially the same as the frequency of the intermediate frequency signal from mixer 122. The output of divider 128 and the amplified intermediate frequency signal from amplifier 124 are both fed into the phase detector 126, which generates a binary error signal (BES) 110 which is either binary HI or binary LO depending on the frequency difference between reference oscillator 104 and the received base station transmitter signal. BES 110 is binary HI if the frequency of reference oscillator 104 is less than the frequency of the received base station transmitter signal. BES 110 is binary LO if the frequency of reference oscillator 104 is greater than the frequency of the received base station transmitter signal. Although theoretically the frequency of reference oscillator 104 and the frequency of the received base station transmitter signal may be identical, such will never occur in practice during operation of cellular telephone 100. Therefore, BES 110 may be chosen to be either binary HI or binary LO if the frequency of reference oscillator 104 and the frequency of the received base station transmitter signal are identical. BES 110 is then fed into microcomputer 102 as an input signal for decision making. Microcomputer 102 is connected to and has control of the frequency of reference oscillator 104 via a communication bus therebetween. During operation of cellular telephone 100, microcomputer 102 loads the current frequency into reference oscillator 104 whenever it is changed.

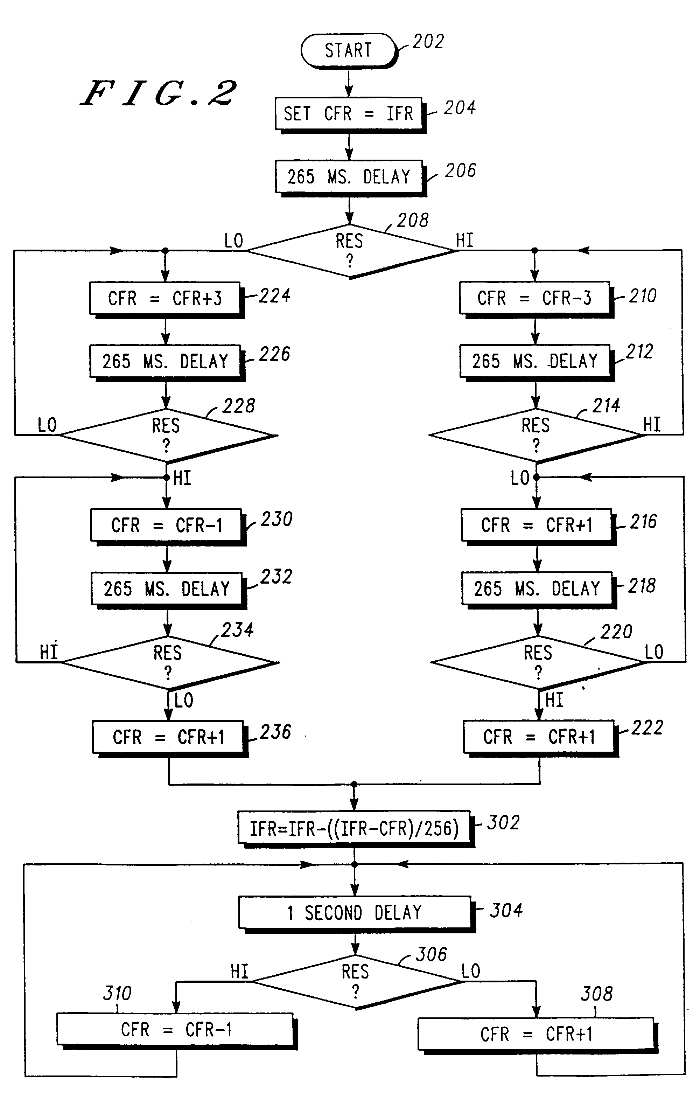

Referring next to Figure 2, there is illustrated a flow chart for the process used by microcomputer 102 in Figure 1 for substantially frequency locking the reference oscillator 104 to the received base station transmitter signal. Entering at START block 202, the process proceeds to block 204, where the current frequency register (CFR) is set equal to the initial frequency register (IFR). Next a 265 ms. delay at block 206 is executed and CFR is loaded into reference oscillator 104. Then, at decision block 208, the binary error signal (RES) 110 is tested for binary HI or LO. If RES is determined to be binary HI, then a sequence beginning with block 210 is executed where three is subtracted from CFR. A decrement of three is selected to produce a relatively large change in the frequency of reference oscillator during initial acquisition of the base station transmitter signal. Next a 265 ms. delay at block 212 is executed and the new CFR is loaded into reference oscillator 104.

Then RES is tested for binary HI or LO in decision block 214. If RES is found to be binary HI, then execution returns to block 210 for continued execution. However, if RES is found to be binary LO, then execution proceeds to block 216 where one is added to CFR. At this point, the frequency of reference oscillator 104 has been adjusted in three unit increments beyond the desired frequency of the received base station transmitter signal, as indicated by the change in binary state of RES from binary HI to LO. Hereafter, a decrement of one is selected to produce a relatively small change in the frequency of reference oscillator during final acquisition of the base station transmitter signal. Next a 265 ms. delay at block 218 is executed and the new CFR is loaded into reference oscillator 104.

Next, in decision block 220, RES is tested for binary HI or LO. If RES is found to be binary LO, execution returns to block 216 for continued execution. However, if RES is found to be binary HI, execution proceeds to block 222 where one is subtracted from CFR. At this point, the frequency of reference oscillator 104 has been adjusted in one unit increments beyond the desired frequency of the received base station transmitter signal, as indicated by the change in binary state of RES from binary LO to HI. Hereafter, execution will proceed to block 302.

Returning to decision block 208, if RES was found to be binary LO, execution proceeds with a sequence beginning with block 224 where three is added to CFR. As explained above, three unit steps are taken in order to produce a relatively large change in the frequency of reference oscillator 104 during initial acquisition of the base station transmitter signal. Next a 265 ms. delay at block 226 is executed and the new CFR is loaded into reference oscillator 104. Then RES is tested for binary HI or LO in decision block 228. If RES is found to be binary LO, execution returns to block 224 for continued execution. If RES is found to be binary HI, then execution continues to block 230 where one is added to CFR. As explained above, one unit steps are taken in order to produce a relatively small change in the frequency of reference oscillator 104 during final acquisition of the base station transmitter signal. Then a 265 ms. delay at block 232 is executed and the new CFR is loaded into reference oscillator 104. Next, RES is tested for binary HI or LO in decision block 234. If RES is found to be binary HI, execution returns to block 230 for continued execution. If RES is found to be binary LO, execution continues to block 236 where one is added to CFR. At this point, execution will proceed to block 302.

Next, execution continues from blocks 236 and 222 to block 302 where IFR is set equal to the value of IFR- (IFR - CFR)/256. At this point, frequency lock has been obtained, and, according to a feature of the present invention, IFR is updated to account for aging that occurred since the last update. Thus, according to the present invention, each time cellular telephone 100 is powered up or each time the base base station transmitter signal is acquired or re-acquired, the initial frequency for reference oscillator 104 is updated and stored for subsequent use. The difference between IFR and CFR is divided by 256 so that IFR is updated by a small amount each time the process of Figure 3 is executed. In other embodiments of cellular telephone 100, the incremental update to IFR may be varied by selecting a different divisor.

Next, execution continues to block 304 where a one second delay is executed and the new CFR is loaded into reference oscillator 104. Once frequency lock has been obtained, the frequency of reference oscillator 104 is changed at one second intervals instead of 265 ms. intervals. In other words, the rate of change of the frequency of reference oscillator 104 is decreased once frequency lock is reached. Then, in decision block 306, RES is tested for binary HI or LO. If RES is found to be binary LO, then execution continues to block 308 where one is added to CFR and the new CFR is loaded into reference oscillator 104. Next, execution returns to block 304 for continued execution. However, if in decision block 306, RES is found to be binary HI, execution would proceed to block 310 where one is subtracted from CFR and the new CFR is loaded into reference oscillator 104. Next, execution would return to block 304 for continued execution until cellular telephone 100 is powered up again or the base station transmitter signal is re-acquired, at which time execution returns to block 202 in Figure 2 to repeat the foregoing process.

In summary, a unique cellular telephone has been described which digitally frequency-locks the transceiver thereof to the frequency of the received signal and corrects the initial turn on frequency of the transceiver each time the transceiver is frequency locked.

## Claims

1. A method for substantially frequency locking a reference oscillator signal of a reference oscillator (104) of a radio transceiver having a microcomputer (102) with a register, to the radio signal received by the radio transceiver, the register storing an initial frequency, said method comprising the steps of:
dividing (102) the reference oscillator signal to produce a divided reference oscillator signal;
generating (120) a synthesizer signal locked to the reference oscillator signal;
mixing (122) the synthesizer signal and the received radio signal to produce an intermediate frequency signal;
comparing (126) the frequency of the divided reference oscillator signal to the frequency of the intermediate frequency signal and producing an error signal (110) having a binary one state if the frequency of the divided reference oscillator signal is less than or equal to the frequency of the intermediate frequency signal, and a binary zero state if the frequency of the divided reference oscillator signal is greater than the frequency of the intermediate frequency signal; and
setting (204) the reference oscillator to an initial stored frequency in the register when a signal is acquired or re-acquired by the radio transceiver;
sampling (208, 228, 214) the binary state of the error signal at successive time intervals following the setting of the reference oscillator to the stored initial frequency, the time intervals having a first predetermined length of time, and increasing (224) the frequency of the reference oscillator by a first predetermined amount if the error signal has a binary one state and decreasing (210) the frequency of the reference oscillator by the first predetermined amount if the error signal has a binary zero state until the binary state of the error signal changes;
when the binary state of the error signal changes a first time following the setting of the reference oscillator to the stored initial frequency, thereafter
sampling the binary state of the error signal at successive time intervals each having a second predetermined length of time and increasing (216) the frequency of the reference oscillator by a second predetermined amount if the error signal has a binary zero state and decreasing (230) the frequency of the reference oscillator by the second predetermined amount if the error signal has a binary one state, said second predetermined amount being less than said first predetermined amount;
when the binary state of the error signal changes a second time (234, 220) following the setting of the reference oscillator to the stored initial frequency, adjusting (302) the stored initial frequency an amount related to the difference between the frequency of the reference oscillator and the stored initial frequency and storing the adjusted initial frequency in the register for use the next time a signal is acquired or re-acquired whereby the initial frequency of the reference oscillator is updated for subsequent use to account for ageing that occurred since a last update.

2. The method according to claim 1, further including the step of repeating the preceding steps each time power is applied to the radio transceiver.

3. The method according to claim 1, further including the step of sampling (306) the binary state of the error signal at successive time intervals each having a third predetermined length of time and increasing (308) the frequency of the reference oscillator by the second predetermined amount if the error signal has a binary one state and decreasing (310) the frequency of the reference oscillator by the second predetermined amount if the error signal has a binary zero state, the third predetermined length of time being greater than the second predetermined length of time.

4. The method according to claim 1, further including the step of determining the transmit frequency of the radio transceiver from the locked reference oscillator signal whereby the transmit frequency is set using the received signal.

## Patentansprüche

1. Verfahren im wesentlichen zum Frequenzverriegeln eines Referenzoszillatorsignals eines Referenzoszillators (104) in einem Funksendeempfänger mit einem Mikrocomputer (102) mit einem Register, mit dem Funksignal, das der Funksendeempfänger empfängt, wobei das Register eine ursprüngliche Frequenz speichert und das Verfahren die Schritte umfaßt:
Teilen (102) des Referenzoszillatorsignals zum Erzeugen eines geteilten Referenzoszillatorsignals,
Erzeugen (120) eines mit dem Referenzoszillatorsignal verriegelten Synthesizersignals und
Mischen (122) des Synthesizersignals und des empfangenen Funksignals zum Erzeugen eines Zwischenfrequenzsignals,
Vergleichen (126) der Frequenz des geteilten Referenzoszillatorsignals mit der Frequenz des Zwischenfrequenzsignals und Erzeugen eines Abweichungssignals (110) mit einem binären Zustand Eins, wenn die Frequenz des geteilten Referenzoszillatorsignals kleiner oder gleich der Frequenz des Zwischenfrequenzsignals ist, und mit einem binären Zustand Null, wenn die Frequenz des geteilten Referenzoszillatorsignals größer als die Frequenz des Zwischenfrequenzsignals ist, und
Einstellen (204) des Referenzoszillators auf eine ursprünglich im Register gespeicherte Frequenz, wenn der Funksendeempfänger ein Signal erhält oder wieder erhält,
Abtasten (208, 228, 214) des binären Zustands des Abweichungssignals in den aufeinanderfolgenden Zeitintervallen, die auf das Einstellen des Referenzoszillators auf die gespeicherte ursprüngliche Frequenz folgen, wobei die Zeitintervalle eine erste vorgegebene Dauer haben, und Erhöhen (224) der Frequenz des Referenzoszillators um einen ersten vorgegebenen Betrag, wenn das Abweichungssignal einen binären Zustand Eins hat, und Verringern (210) der Frequenz des Referenzoszillators um den ersten vorgegebenen Betrag, wenn das Abweichungssignal einen binären Zustand Null hat, bis sich der binäre Zustand des Abweichungssignals ändert,
dann, wenn der binäre Zustand des Abweichungssignals nach dem Einstellen des Referenzoszillators auf die gespeicherte ursprünglichen Frequenz sich zum ersten Mal ändert, Abtasten des binären Zustands des Abweichungssignals in aufeinanderfolgenden Zeitintervallen, die jeweils eine zweite vorgegebene Dauer haben, und Erhöhen (216) der Frequenz des Referenzoszillators um einen zweiten vorgegebenen Betrag, wenn das Abweichungssignal einen binären Zustand Null hat, und Verringern (230) der Frequenz des Referenzoszillators um den zweiten vorgegebenen Betrag, wenn das Abweichungssignal einen binären Zustand Eins hat, wobei der zweite vorgegebene Betrag kleiner als der erste vorgegebene Betrag ist,
dann, wenn der binäre Zustand des Abweichungssignals nach dem Einstellen des Referenzoszillators auf die gespeicherte ursprüngliche Frequenz sich ein zweites Mal (234, 220) ändert, Ändern (302) der gespeicherten ursprünglichen Frequenz um einen Betrag, der in Beziehung steht zum Unterschied zwischen der Frequenz des Referenzoszillators und der gespeicherten ursprünglichen Frequenz, und Speichern der eingestellten ursprünglichen Frequenz im Register zur Verwendung, wenn ein Signal beim nächsten Mal erhalten oder erneut erhalten wird, wodurch die ursprüngliche Frequenz des Referenzoszillators für die nachfolgende Verwendung aktualisiert wird, um eine Alterung seit der letzten Aktualisierung zu berücksichtigen.

2. Verfahren nach Anspruch 1, das außerdem den Schritt Wiederholen der vorausgehenden Schritte, immer wenn der Funksendeempfänger Strom erhält, umfaßt.

3. Verfahren nach Anspruch 1, das außerdem den Schritt Abtasten (306) des binären Zustands des Abweichungssignals in aufeinanderfolgenden Zeitintervallen umfaßt, die jeweils eine dritte vorgegebene Dauer haben, und Erhöhen (308) der Frequenz des Referenzoszillators um den zweiten vorgegebenen Betrag, wenn das Abweichungssignal einen binären Zustand Eins hat, und Verringern (310) der Frequenz des Referenzoszillators um den zweiten vorgegebenen Betrag, wenn das Abweichungssignal einen binären Zustand Null hat, wobei die dritte vorgegebene Dauer größer als die zweite vorgegebene Dauer ist.

4. Verfahren nach Anspruch 1, das außerdem den Schritt Bestimmen der Sendefrequenz des Funksendeempfängers aus dem verriegelten Referenzoszillatorsignal umfaßt, wodurch die Sendefrequenz mit dem Empfangssignal eingestellt wird.

## Revendications

1. Procédé permettant essentiellement d'asservir en fréquence un signal d'oscillateur de référence (104) d'un émetteur-récepteur radio ayant un micro-ordinateur (102) avec un registre, au signal radio reçu par l'émetteur-récepteur radio, le registre permettant de stocker une fréquence initiale, ledit procédé comprenant les étapes consistant à :
diviser (102) le signal de l'oscillateur de référence pour produire un signal d'oscillateur de référence divisé ;
générer (120) un signal de synthétiseur asservi au signal de l'oscillateur de référence ;
mélanger (122) le signal du synthétiseur et le signal radio reçu pour produire un signal de fréquence intermédiaire ;
comparer (126) la fréquence du signal d'oscillateur de référence divisé et la fréquence du signal de fréquence intermédiaire et produire un signal d'erreur (110) ayant un état 1 binaire si la fréquence du signal d'oscillateur de référence divisé est inférieure ou égale à la fréquence du signal de fréquence intermédiaire et un état 0 binaire si la fréquence du signal d'oscillateur de référence divisé est supérieure ou égale à la fréquence du signal de fréquence intermédiaire ; et
régler (204) l'oscillateur de référence sur une fréquence initiale mémorisée dans le registre lorsqu'un signal est reçu ou reçu une nouvelle fois par l'émetteur-récepteur radio ;
échantillonner (208, 228, 214) l'état binaire du signal d'erreur à des intervalles de temps successifs, après le réglage de l'oscillateur de référence sur la fréquence initiale mémorisée, les intervalles de temps ayant une première durée prédéterminée et augmenter (224) la fréquence de l'oscillateur de référence d'une première valeur prédéterminée si le signal d'erreur a un état 1 binaire et réduire (210) la fréquence de l'oscillateur de référence d'une première valeur prédéterminée si le signal d'erreur a un état 0 binaire, jusqu'à ce que l'état binaire du signal d'erreur change ;
lorsque l'état binaire du signal d'erreur change une première fois après le réglage de l'oscillateur de référence sur la fréquence initiale mémorisée, échantillonner l'état binaire du signal d'erreur à des intervalles de temps successifs, chacun ayant une deuxième durée prédéterminée et augmenter (216) la fréquence de l'oscillateur de référence d'une deuxième valeur prédéterminée si le signal d'erreur a un état 0 binaire et réduire (230) la fréquence de l'oscillateur de référence d'une deuxième valeur prédéterminée si le signal d'erreur a un état 1 binaire, ladite deuxième valeur prédéterminée étant inférieure à ladite première valeur prédéterminée ;
lorsque l'état binaire du signal d'erreur change une deuxième fois (234, 220) après le réglage de l'oscillateur de référence sur la fréquence initiale mémorisée, ajuster (302) la fréquence initiale mémorisée d'une valeur correspondant à la différence entre la fréquence de l'oscillateur de référence et la fréquence initiale mémorisée et mémoriser la fréquence initiale ajustée dans le registre afin qu'elle puisse être utilisée la prochaine fois qu'un signal sera reçu ou de nouveau reçu, la fréquence initiale de l'oscillateur de référence étant ainsi mise à jour pour une utilisation ultérieure pour tenir compte des changements intervenus depuis la dernière mise à jour.

2. Procédé selon la revendication 1, comprenant en outre l'étape consistant à répéter les étapes précédentes chaque fois que l'émetteur-récepteur radio est mis sous tension.

3. Procédé selon la revendication 1, comprenant en outre l'étape consistant à échantillonner (306) l'état binaire du signal d'erreur à des intervalles de temps successifs, chacun ayant une troisième durée prédéterminée et augmenter (308) la fréquence de l'oscillateur de référence d'une deuxième valeur prédéterminée si le signal d'erreur a un état 1 binaire et réduire (310) la fréquence de l'oscillateur de référence d'une deuxième valeur prédéterminée si le signal d'erreur a un état 0 binaire, ladite troisième durée prédéterminée étant supérieure à ladite deuxième durée prédéterminée.

4. Procédé selon la revendication 1, comprenant en outre l'étape consistant à déterminer la fréquence de transmission de l'émetteur-récepteur radio à partir d'un signal d'oscillateur de référence asservi, grâce à quoi la fréquence de transmission est réglée en utilisant le signal reçu.
